# EUROPEAN PATENT SPECIFICATION

(11) **EP 0 869 372 B1**
(45) Date of publication and mention of the grant of the patent: **09.05.2007**
(21) Application number: 98302498.5
(22) Date of filing: 31.03.1998
(51) Int. Cl.: G01R 33/035

(54) **Superconducting quantum interference device and non-destructive evaluation apparatus using the same**
Supraleitende Quanteninterferenzanordnung und Einrichtung zur zerstörungsfreien Prüfung unter Verwendung derselben
Dispositif supraconducteur à interférence quantique et dispositif d'essai non destructif l'utilisant

(30) Priority: 31.03.1997 JP 8167697
(43) Date of publication of application: 07.10.1998
(73) Proprietor: SII NanoTechnology Inc., Chiba-shi, Chiba 261-8507 (JP)
(72) Inventor: Morooka, Toshimitsu, c/o Seiko Instruments Inc., Chiba-shi, Chiba (JP); Nakayama, Satoshi, c/o Seiko Instruments Inc., Chiba-shi, Chiba (JP); Odawara, Akikazu, c/o Seiko Instruments Inc., Chiba-shi, Chiba (JP); Chinone, Kazuo, c/o Seiko Instruments Inc., Chiba-shi, Chiba (JP)
(74) Representative: Sturt, Clifford Mark

(56) References cited:
- EP-A- 0 435 651
- EP-A- 0 699 921
- WO-A-91/02259

## Description

The present invention relates to a superconducting quantum interference device (hereinafter abbreviated as SQUID) for detecting a very small magnetic field, current, voltage, electromagnetic wave or the like and more particularly to a structure of a detecting coil of a SQUID flux meter having a high spatial resolution.

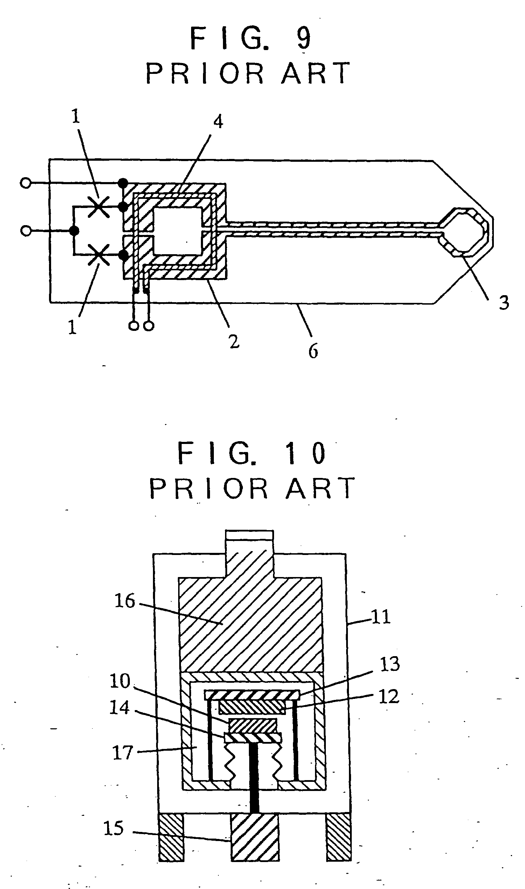

FIG. 9 is a structural drawing of a prior art SQUID. A superconducting ring comprising Josephson junctions 1, a washer coil 2 and a detecting coil 3 is formed on a substrate 6. In FIG. 9, the Josephson junction 1 is denoted simply by a symbol. A feedback-modulation coil 4 for FLL (Flux Locked Loop)-driving the SQUID is magnetically coupled to the washer coil 2. Magnetic flux detected by the detecting coil is directly connected with the superconducting ring. This SQUID is an integrated SQUID in which all the components such as the Josephson junctions 1 and the detecting coil 3 are formed on the substrate 6 by a superconductive thin film. The superconductive thin film composing the SQUID is an Nb thin film, and nb/a1-AlOx/Nb tunnel junction is used for the Josephson junction.

FIG. 10 shows a scanning SQUID microscope constructed by using the SQUID shown in FIG. 9. A sample 12 is attached on a sample holder 13. The SQUID 10 is mounted on a SQUID holder 14 and the surface of the sample 12 is scanned by an XYZ scanning controller 15. The SQUID 10, the sample 12, the sample holder 13 and the SQUID holder 14 are stored in a vacuum chamber 17 within a cryostat 11. The vacuum chamber 17 is cooled by liquid helium 16, i.e. coolant.

The scanning SQUID microscope measures a distribution of magnetic field in an area of micron size on the surface of the sample. It is necessary to miniaturise the detecting coil 3 in order to enhance the spatial resolution of the SQUID microscope. The SQUID 10 thus has to have a compact structure in which the detecting coil is integrated using a superconductive thin film. It is also necessary to put the detecting coil 3 in close proximity to the sample 12.

It is also required to vary the temperature of the sample in the SQUID microscope. For instance, there is a requirement to measure the sample when the temperature of the sample is at a temperature higher than a critical temperature of the superconductor comprising the SQUID. Thus, the temperature around the detecting coil 3 disposed in close proximity to the sample 12 exceeds the critical temperature of the detecting coil in the prior art SQUID. In such a case, the detecting coil cannot maintain the superconducting state and cannot detect the magnetic flux properly.

Thus, it is difficult to vary the temperature of the sample while enhancing the spatial resolution of the SQUID microscope.

The critical temperature of the Josephson junction section is equal to the critical temperature of the detecting coil. When a SQUID microscope is constructed using the SQUID, and the sample is measured when the temperature of the sample is higher than the critical temperature of the SQUID; the temperature around the detecting coil which is disposed in close proximity to the sample can exceed the critical temperature. Then, the detecting coil is unable to maintain the superconducting state and is unable to detect magnetic flux properly.

WO 91/02259 describes a biomagnetometer comprising a SQUID detector, a pickup coil and leads connecting the pickup coil to the SQUID, wherein the leads and the pickup coil are made from a superconducting material having a higher critical temperature than that of the superconducting material used to form the SQUID in order to reduce the cooling requirements for the leads and the pickup coil.

EP 0699921 describes a probe for a miniaturised scanning magnetometer formed on a chip and comprising a SQUID, an input coil magnetically coupled to the SQUID, and a pickup coil connected to the input coil by a stripline, all of which components are formed from Niobium.

EP 0435651 describes a SQUID magnetometer comprising a SQUID detector, a pickup coil magnetically coupled to the SQUID and a feedback circuit for feeding magnetic flux back to the pickup coil circuit in response to the output of the SQUID.

It is an object of the present invention to provide a SQUID for a SQUID microscope that can operate properly even when a sample temperature is higher than the critical temperature of the Josephson junction.

It is another object of the present invention to provide a SQUID having the advantage that the detecting coil may have various sizes and functions and may be matched to the task to be undertaken.

It is another object of the invention to provide a SQUID which is readily fabricated.

According to the present invention there is provided an integrated superconducting quantum interference device formed on a substrate using a superconductive thin film and with which a detecting coil is integrated comprising:
a superconducting ring containing Josephson junctions;
a feedback-modulation coil magnetically coupled with the superconducting ring; and
a miniaturized detecting coil formed by a superconductive film material having a critical temperature higher than the critical temperature of the superconductive film material used for said Josephson junctions.

With the present invention, it is possible to provide a SQUID made of a Nb superconductor with a detecting coil made of a high temperature superconductor, which would conventionally be difficult because it is difficult to connect them in a superconductive manner. According to the present invention they may be readily combined because the different superconductive materials may be formed on separate substrates and no superconductive connection is required. That is, the superconducting loop comprising the input coil and the detecting coil can be formed on a substrate different from the Josephson junctions. The two substrates can be joined so as to magnetically couple the input coil with the superconducting ring.

A SQUID according to the present invention can readily be fabricated by providing the input coil magnetically coupled with the washer coil. Further, the whole superconducting loop comprising the detecting coil and the input coil is formed using a superconductive film material having a critical temperature higher than the critical temperature of the superconductive film material used for forming the Josephson junctions. In this arrangement, the detecting coil need not be connected with the input coil in a superconductive manner.

Embodiments of the present invention will now be described by way of further example only and with reference to the accompanying drawings, in which:-
FIG. 1 is a structural drawing showing a SQUID according to a first embodiment of the present invention;
FIG. 2 is a structural drawing showing a scanning SQUID microscope using a SQUID of the present invention;
FIGS. 3A and 3B are structural drawings showing a SQUID according to a second embodiment of the present invention;
FIG. 4 is a structural drawing showing a SQUID according to a third embodiment of the present invention;
FIGS. 5A and 5B are structural drawings showing a SQUID according to a fourth embodiment of the present invention;
FIG. 6 is a structural drawing showing a SQUID according to a fifth embodiment of the present invention;
FIGS. 7A and 7B and 7C are structural drawings showing a SQUID according to a sixth embodiment of the present invention;
FIGS. 8A and 8B and 8C are structural drawings showing a SQUID according to a seventh embodiment of the present invention;
FIG. 9 is a structural drawing showing a prior art SQUID; and
FIG. 10 is a structural drawing showing a scanning SQUID using the prior art SQUID.

According to the present invention, the detecting coil of the SQUID is made of a superconductive thin film material having a higher critical temperature than the critical temperature of the superconductive film material composing the Josephson junctions. When a SQUID microscope is constructed by using the SQUID comprising the detecting coil having such a high critical temperature, measurement may be carried out with the detecting coil in close proximity to the sample even if the temperature of the sample is higher than the critical temperature of the Josephson junction section.

That is, while still being integrated into a SQUID, the detecting coil is made of a superconductive thin film material having a higher critical temperature than the critical temperature of a superconductive film material used to implement the Josephson junction.

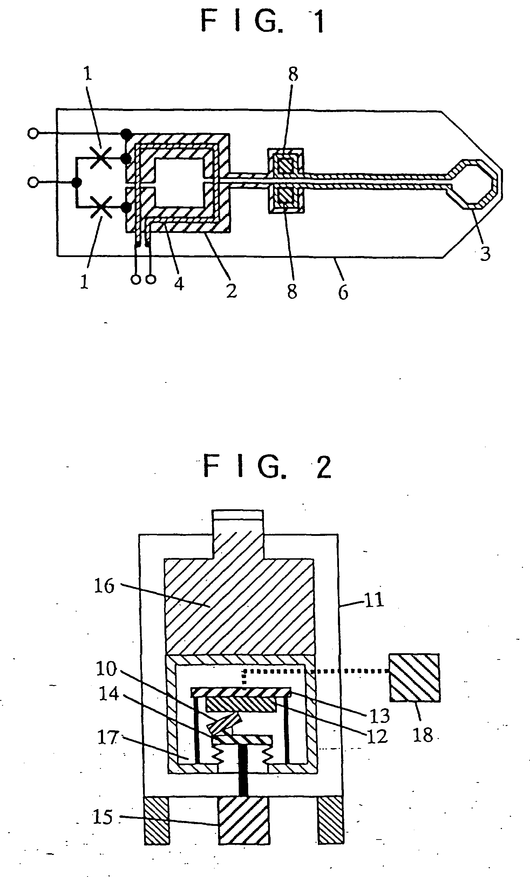

FIG. 1 is a structural drawing of a SQUID according to a first embodiment of the present invention. A superconducting ring comprising two Josephson junctions 1, a washer coil 2 and a detecting coil 3 is formed on a substrate 6 using a superconductive thin film. This structure is referred to as a direct coupling system in which part of the superconducting ring is used as the detecting coil. The Josephson junction 1 is denoted simply by a symbol. A feedback-modulation coil 4 for FLL-driving the SQUID is magnetically coupled to the washer coil 2. The SQUID is miniaturised and is arranged so as to have a high spatial resolution by integrating all the components of the SQUID using superconductive thin films on the substrate 6. The detecting coil 3 is made of a superconductive film material having a higher critical temperature than the critical temperature of the superconductive film material forming the Josephson junction section. The coil 3 is connected with the washer coil 2 at superconducting connecting sections S. For instance, when a tunnel junction of Nb/Al-AlOx/Nb is used for the Josephson junction 1, a superconductive thin film having a high critical temperature such as NbN and YBCO (which are high temperature superconducting materials) is adopted for the detecting coil 3.

FIG. 2 is a structural drawing showing a scanning SQUID microscope using a SQUID according to the present invention. A sample 12 is attached on a sample holder 13. The SQUID 10 is mounted on a SQUID holder 14 and the surface of the sample 12 is scanned by an XYZ scanning controller 15. The SQUID 10, the sample 12, the sample holder 13 and the SQUID holder 14 are stored in a vacuum chamber 17 within a cryostat 11. The vacuum chamber 17 is cooled by liquid helium 16, i.e. coolant. The temperature of the sample 12 may be varied using a temperature controller 18. The SQUID 10 is set at an angle to the sample so that a temperature gradient can be obtained between the Josephson junction section and the detecting coil. The SQUID 10 is also set so that the detecting coil 3 is closer to the sample 12 and the Josephson junction section is further from the sample.

This arrangement allows magnetic flux to be measured by providing a temperature gradient such that the temperature of the Josephson junction section is lower than its critical temperature while the temperature of the sample is higher than the critical temperature of the Josephson junction section. Even if the sample is in close proximity to the detecting coil, the whole SQUID may be kept in the superconducting state because the critical temperature of the detecting coil is high.

Although Nb has been exemplified as the Josephson junction material in the present embodiment, any material may be used as long as it is a superconductive film material which can form a SQUID. Examples are NbN, Pb and YBCO. The effect of the invention may be obtained by using a material whose critical temperature is higher than that of the Josephson junction for the detecting coil. The coolant used may be any coolant, such as liquid nitrogen, as long as it can deal with the critical temperature of the Josephson junction. It is also possible to use a refrigerator.

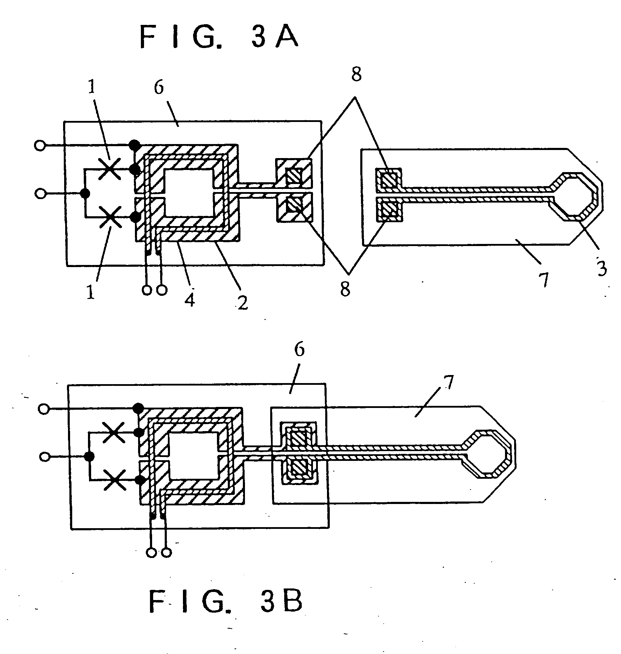

FIGS. 3A and 3B are structural drawings of a SQUID according to a second embodiment of the present invention. The two Josephson junctions 1 and the washer coil 2 are formed on the substrate 6 using a superconductive thin film. The feedback-modulation coil 4 for FLL-driving the SQUID is magnetically coupled to the washer coil 2. The detecting coil 3 is formed on a detecting coil substrate 7 which is different from the substrate carrying the Josephson junction 1. The detecting coil 3 is made of a superconductive film material having a higher critical temperature than the critical temperature of the superconductive film material used to form the Josephson junction part. A superconducting ring is made by connecting the detecting coil 3 with the washer coil 2 in a superconductive manner by pasting the substrate 6 to substrate 7 and by pressure-welding the superconducting sections S by using superconducting bumps or the like.

The SQUID of the present embodiment has the merit that it allows the detecting coil to be selected according to its use, i.e., having various sizes and functions or adapted to the temperature of the sample being measured.

Although the substrate 6 is connected with the detecting coil substrate 7 by pressure-welding in the present embodiment, it is also possible to connect them by bonding using superconducting wires made of Pb-In-Au or the Like.

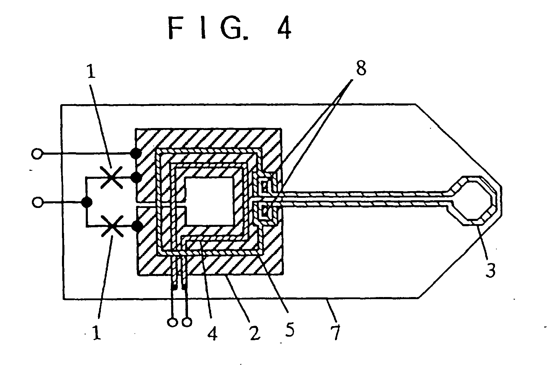

FIG. 4 is a structural drawing of a SQUID according to a third embodiment of the present invention. The superconducting ring comprising the two Josephson junctions 1 and the washer coil 2 is formed on the substrate 6 using a superconductive thin film. The feedback-modulation coil 4 and an input coil 5 for transmitting magnetic flux detected by the detecting coil to the washer coil 2 are also formed on substrate 6. They are magnetically coupled to the washer coil 2. The detecting coil 3 is made of a superconductive film material having a higher critical temperature than the critical temperature of the superconductive film material used to form the Josephson junction section. It is connected with the input coil 5 at the superconducting connecting sections 8.

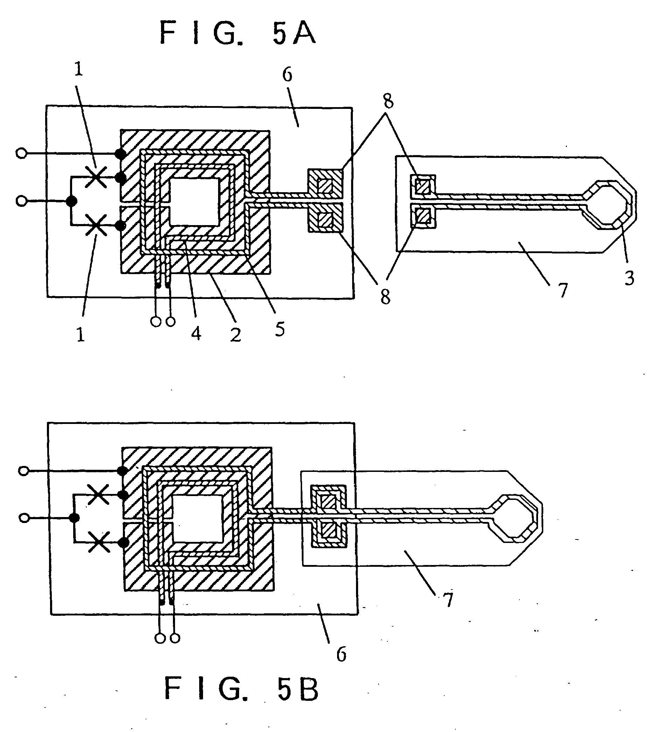

FIGS. 5A and 5B are structural drawings of a SQUID according to a fourth embodiment of the present invention. In the SQUID shown in the third embodiment, the detecting coil 3 is formed on the detecting coil substrate 7 which is different from the Josephson junction section. The substrates are pasted to connect the input coil 5 in the superconductive manner. Similarly to the second embodiment, the present embodiment has the merit that it allows the detecting coil suited for a particular use to be selected.

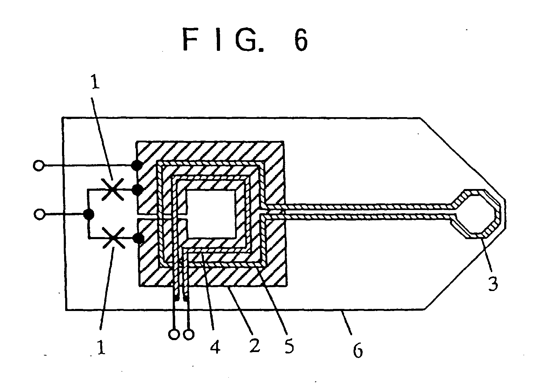

FIG. 6 is a structural drawing of a SQUID according to a fifth embodiment of the present invention. In the SQUID shown in the fifth embodiment, the whole superconducting loop comprising the detecting coil 3 and the input coil 5 is made of a superconductive film material having a critical temperature higher than the critical temperature of the superconductive film material used to form the Josephson junction section. The present embodiment allows the SQUID to be readily fabricated because the detecting coil needs not be connected with the input coil in a superconductive manner.

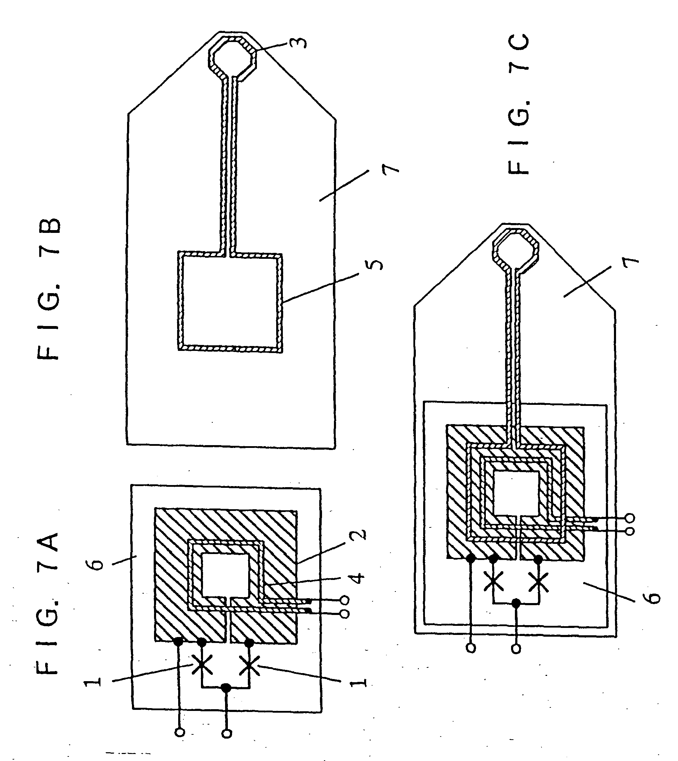

FIGS. 7A and 7B and 7C are structural drawings of a SQUID according to a sixth embodiment of the present invention. The superconducting ring comprising two Josephson junctions 1 and the washer coil 2 is formed on the substrate 6 using a superconductive thin film. The feedback-modulation coil 4 is magnetically coupled to the washer coil 2. The superconducting loop comprising the detecting coil 3 and the input coil 5 is formed on the detecting coil substrate 7 which is different from the substrate carrying the Josephson junctions 1. Coils 3 and 5 are formed using a superconductive film material having a critical temperature higher than the critical temperature of the superconductive film material used to form the Josephson section. The substrate 6 is pasted with the detecting coil substrate 7 so that the input coil 7 is magnetically coupled with the washer coil 2. The present embodiment allows different superconducting materials to be formed on the separate substrates. It provides a SQUID made of a Nb superconductor with the detecting coil made of a high temperature superconductor. These components are difficult to connect in a superconductive manner. In this embodiment they are readily combined because no superconductive connection is required.

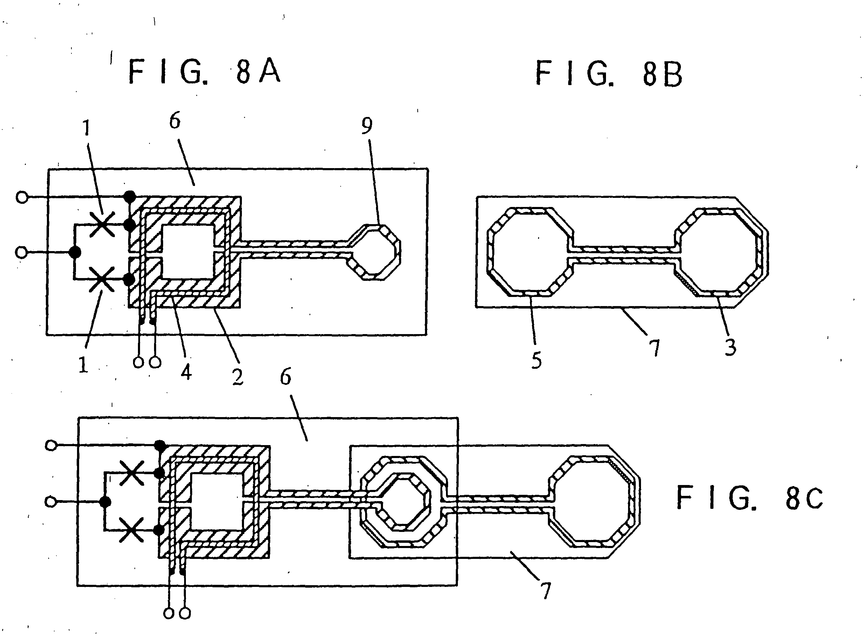

FIGS. 8A and 8B and 8C are structural drawings of a SQUID according to a seventh embodiment of the present invention. Substrate 6 carries a SQUID having a detecting coil 9. Substrate 7 carries a superconducting loop comprising the detecting coil 5. The substrates 6 and 7 are joined together, as shown. Magnetic flux detected by the detecting coil 3 on the detecting coil substrate 7 is transmitted from the input coil 5 to the detecting coil 9 on the SQUID substrate 6. That is, the detecting coil 9 on substrate 6 is magnetically connected with the input coil 5 on the detecting coil substrate 7. The shape of the detecting coil 3 may be varied by selecting among a plurality of detecting coil substrates. It is possible to deal with the case when there is a large difference between the sample temperature and the critical temperature of the Josephson junction, by combining substrates having different critical temperatures

It is also possible to arrange to detect a magnetic field directly by the superconducting ring, by forming part of the above-mentioned superconducting ring using a superconductive film material having a critical temperature higher than the critical temperature of the Josephson junction section.

It is possible to integrate the detecting coil by forming the detecting coil on a substrate which is different from that of the Josephson junction section and by joining the substrates together so as to connect them in a superconductive manner.

It is possible to arrange to transmit the magnetic flux detected by the detecting coil to the superconducting ring via the input coil. The input coil is magnetically coupled to the superconducting ring and the detecting coil is connected to the input coil in a superconductive manner.

It is also possible to form the whole superconducting loop, comprising the input coil and the detecting coil, using a superconductive film material having a critical temperature higher than that of the Josephson junction section.

Further, it is possible to arrange to magnetically couple the input coil with the superconducting ring forming the superconducting loop, comprising the input coil and the detecting coil, on a substrate which is different from the Josephson junction section.

## Claims

1. An integrated superconducting quantum interference device formed on a substrate (6) using a superconductive thin film and with which a detecting coil (3) is integrated comprising:
a superconducting ring (2) containing Josephson junctions (1);
a feedback-modulation coil (4) magnetically coupled with the superconducting ring (2); and **characterised by**
a miniaturized detecting coil (3) formed by a superconductive film material having a critical temperature higher than the critical temperature of the superconductive film material used for said Josephson junctions (1).

2. A superconducting quantum interference device as claimed in Claim 1, wherein part of said superconducting ring (2) is said detecting coil (3).

3. A superconducting quantum interference device as claimed in Claim 2, wherein said detecting coil (3) is formed on a substrate (7) which is different from that containing the Josephson junctions (1).

4. A superconducting quantum interference device as claimed in Claim 1, further comprising an input coil (5) magnetically coupled with the superconducting ring (2), wherein said miniaturized detecting coil (3) forms a superconducting loop with the input coil (5).

5. A superconducting quantum interference device as claimed in Claim 4, wherein said detecting coil (3) is formed on a substrate (7) which is different from that of the Josephson junctions (1).

6. A superconducting quantum interference device as claimed in Claim 4, wherein said superconducting loop comprising said detecting coil (3) and said input coil (5) is formed by a superconductive film material having a critical temperature higher than the critical temperature of the superconductive film material used to form said Josephson junctions (1).

7. A superconducting quantum interference device as claimed in Claim 6, wherein said superconducting loop is formed on a substrate (7) which is different from that of the Josephson junctions (1) and magnetic flux detected by said detecting coil (3) is able to be transmitted to said superconducting ring (2) via said input coil (5).

8. A non-destructive evaluation apparatus comprising a superconducting quantum interference device as claimed in any preceding Claim.

9. A scanning superconducting quantum interference device microscope comprising a superconducting quantum interference device as claimed in any of claims 1 to 7.

10. A microscope as claimed in claim 9, wherein the superconductive quantum interference device is inclined with respect to a sample holder so as to enable a temperature gradient to be established between different parts of the device.

## Patentansprüche

1. Integrierte supraleitende Quanteninterferenzanordnung, die auf einem Substrat (6) unter Verwendung eines supraleitenden Dünnfilms gebildet ist und mit der eine Erfassungsspule (3) integriert ist, umfassend:
einen supraleitenden Ring (2) der Josephson-Kontakte (1) enthält;
eine Rückkopplungs-Modulationsspule (4), die magnetisch mit dem supraleitenden Ring (2) gekoppelt ist; und **gekennzeichnet durch**
eine miniaturisierte Erfassungsspule (3), die aus einem supraleitenden Filmmaterial mit einer kritischen Temperatur gebildet ist, die höher als die kritische Temperatur des supraleitenden Filmmaterials ist, das für die Josephson-Kontakte (1) verwendet wird.

2. Supraleitende Quanteninterferenzanordnung nach Anspruch 1, wobei ein Teil des supraleitenden Rings (2) die Erfassungsspule (3) ist.

3. Supraleitende Quanteninterferenzanordnung nach Anspruch 2, wobei die Erfassungsspule (3) auf einem Substrat (7) gebildet ist, das sich von jenem unterscheidet, das die Josephson-Kontakte (1) enthält.

4. Supraleitende Quanteninterferenzanordnung nach Anspruch 1, des Weiteren umfassend eine Eingangsspule (5), die magnetisch mit dem supraleitenden Ring (2) gekoppelt ist, wobei die miniaturisierte Erfassungsspule (3) eine supraleitende Schleife mit der Eingangsspule (5) bildet.

5. Supraleitende Quanteninterferenzanordnung nach Anspruch 4, wobei die Erfassungsspule (3) auf einem Substrat (7) gebildet ist, das sich von jenem der Josephson-Kontakte (1) unterscheidet.

6. Supraleitende Quanteninterferenzanordnung nach Anspruch 4, wobei die supraleitende Schleife, die die Erfassungsspule (3) und die Eingangsspule (5) umfasst, aus einem supraleitenden Filmmaterial mit einer kritischen Temperatur gebildet ist, die höher als die kritische Temperatur des supraleitenden Filmmaterials ist, das zur Bildung der Josephson-Kontakte (1) verwendet wird.

7. Supraleitende Quanteninterferenzanordnung nach Anspruch 6, wobei die supraleitende Schleife auf einem Substrat (7) gebildet ist, das sich von jenem der Josephson-Kontakte (1) unterscheidet, und ein Magnetfluss, der von der Erfassungsspule (3) erfasst wird, zu dem supraleitenden Ring (2) über die Eingangsspule (5) übertragen werden kann.

8. Zerstörungsfreie Evaluationsvorrichtung umfassend eine supraleitende Quanteninterferenzanordnung nach einem der vorangehenden Ansprüche.

9. Rastermikroskop mit einer supraleitenden Quanteninterferenzanordnung, umfassend eine supraleitende Quanteninterferenzanordnung nach einem der Ansprüche 1 bis 7.

10. Mikroskop nach Anspruch 9, wobei die supraleitende Quanteninterferenzanordnung in Bezug auf eine Probenhalterung so geneigt ist, dass ein Temperaturgradient zwischen verschiedenen Teilen der Anordnung erzeugt werden kann.

## Revendications

1. Dispositif intégré supraconducteur à interférence quantique formé sur un substrat (6) en utilisant une pellicule mince supraconductrice et avec une bobine de détection (3) intégrée avec, comprenant :
un anneau supraconducteur (2) contenant des jonctions Josephson (1) ;
une bobine à modulation de rétroaction (4) couplée magnétiquement avec l'anneau supraconducteur (2); et **caractérisé par**
une bobine de détection miniaturisée (3) formée par une matière de pellicule supraconductrice ayant une température critique plus élevée que la température critique de la matière de pellicule supraconductrice utilisée pour lesdites jonctions de Josephson (1).

2. Dispositif supraconducteur à interférence quantique tel que revendiqué par la revendication 1, une partie dudit anneau supraconducteur (2) étant ladite bobine de détection (3).

3. Dispositif supraconducteur à interférence quantique tel que revendiqué par la revendication 2, ladite bobine de détection (3) étant formée sur un substrat (7) qui est différent de celui contenant les jonctions de Josephson (1).

4. Dispositif supraconducteur à interférence quantique tel que revendiqué par la revendication 1, comprenant en outre une bobine d'entrée (5) couplée magnétiquement avec l'anneau supraconducteur (2), ladite bobine de détection miniaturisée (3) formant une boucle supraconductrice avec la bobine d'entrée (5).

5. Dispositif supraconducteur à interférence quantique tel que revendiqué par la revendication 4, ladite bobine de détection (3) étant formée sur un substrat (7) qui est différent de celui des jonctions Josephson (1).

6. Dispositif supraconducteur à interférence quantique tel que revendiqué par la revendication 4, ladite boucle supraconductrice comprenant ladite bobine de détection (3), et ladite bobine d'entrée (5) étant formée par une matière de pellicule supraconductrice ayant une température critique plus élevée que la température critique de la matière de pellicule supraconductrice utilisée pour former lesdites jonctions de Josephson (1).

7. Dispositif supraconducteur à interférence quantique tel que revendiqué par la revendication 6, ladite boucle supraconductrice étant formée sur un substrat (7) qui est différent de celui des jonctions de Josephson (1), et un flux magnétique détecté par ladite bobine de détection (3) pouvant être transmis audit anneau supraconducteur (2) via ladite bobine d'entrée (5).

8. Appareil d'évaluation non-destructif comprenant un dispositif supraconducteur à interférence quantique tel que revendiqué par l'une quelconque des revendications précédentes.

9. Microscope à balayage à dispositif supraconducteur à interférence quantique comprenant un dispositif supraconducteur à interférence quantique tel que revendiqué par l'une quelconque des revendications 1 à 7.

10. Microscope tel que revendiqué par la revendication 9, le dispositif supraconducteur à interférence quantique étant incliné par rapport à un porte-échantillon de manière à permettre la détermination d'un gradient de température entre différentes parties du dispositif.
